# EUROPÄISCHE PATENTSCHRIFT

(11) **EP 0 539 776 B1**
(45) Veröffentlichungstag und Bekanntmachung des Hinweises auf die Patenterteilung: **14.01.1998**
(21) Anmeldenummer: 92117175.7
(22) Anmeldetag: 08.10.1992
(51) Int. Cl.: H03H 17/06

(54) **Einrichtung zur Gewinnung zweier in Quadraturphasenbeziehung stehender Signale aus einem digitalen Signal**
Apparatus for deriving two quadrature signals from a digital signal
Dispositif pour obtenir, à partir d'un signal numérique, deux signaux de quadrature

(30) Priorität: 26.10.1991 DE 4135335
(43) Veröffentlichungstag der Anmeldung: 05.05.1993
(73) Patentinhaber: GRUNDIG Aktiengesellschaft, 90762 Fürth (DE)
(72) Erfinder: Triebel, Siegbert, Dipl.-Ing., Grundig E.M.V., Kurgartenstrasse 37, W-8510 Fürth/Bay (DE)

(56) Entgegenhaltungen:
- EP-A- 0 209 928
- US-A- 3 482 190
- SOLID STATE ELECTRONICS Bd. 19, Nr. 3 , März 1976 , OXFORD GB Seiten 201 - 207 A. CHOWANIEC ET AL. 'A WIDE-BAND QUADRATURE PHASING SYSTEM USING CHARGE TRANSFER DEVICES'
- IEEE TRANSACTIONS ON CONSUMER ELECTRONICS Bd. 31, Nr. 3 , August 1985 , NEW YORK, US Seiten 374 - 377 S. MEHRGARDT 'DIGITAL SIGNAL PROCESSING IN VIDEO TAPE RECORDERS'

## Beschreibung

Die Erfindung betrifft eine Einrichtung zur Gewinnung zweier in Quadraturphasenbeziehung stehender Signale aus einem digitalen Signal.

Überall dort, wo zur digitalen Signalverarbeitung die Quadraturkomponente eines zu verarbeitenden Eingangssignals benötigt wird, wird die Quadraturkomponente üblicherweise durch eine Phasenverschiebung um 90^{o} aus dem zu verarbeitenden Eingangssignal erzeugt. Dazu kann beispielsweise ein Hilbert-Transformator verwendet werden. Um die Signallaufzeit durch den Hilbert-Transformator auszugleichen, so daß das Eingangssignal zur Quadraturkomponente die korrekte Phasenbeziehung aufweist, wird das Eingangssignal durch einen Verzögerer um die Laufzeit des Hilbert-Transformators verzögert, wodurch die sogenannte Inphasenkomponente entsteht.

Aus dem Aufsatz ,,A WIDE-BAND QUADRATURE PHASING SYSTEM USING CHARGE TRANSFER DEVICES", von A. Chowaniec und G.S. Hobson, erschienen in Solid-State Electronics, 1976, Vol. 19, Seiten 201-207, ist eine Einrichtung zur Gewinnung zweier in Quadraturphasenbeziehung stehender Signale aus einem digitalen Signal bekannt, bei der zwei Filter mit endlicher Impulsantwort verwendet werden, wobei die Filter eine gemeinsame Verzögerungseinheit verwenden. Die Koeffizienten der Filter sind dabei so festgelegt, daß die Ausgangssignale der Filter in Quadraturphasenbeziehung stehen. Die Quadraturphasenbeziehung wird durch eine Phasenverschiebung um 90 ° erreicht.

Die bekannte Filteranordnung weist jedoch, ähnlich wie der Hilbert-Transformator, den Nachteil auf, daß der Betragsfrequenzgang bei den Frequenzen 0 Hz und Vielfachen der halben Abtastfrequenz Nullstellen hat.

Ein Anwendungsbeispiel für die Verwendung von Inphasen- und Quadraturkomponente ist die digitale FM-Demodulation bei der Verarbeitung von Videosignalen. Der Aufbau eines derartigen Demodulators mit Hilbert-Transformator und Verzögerer zur Erzeugung von Inphasen- und Quadraturkomponente ist in dem Aufsatz "Digital Signal Processing in Video Tape Recorders", erschienen in IEEE Transactions on Consumer Electronics, Vol. CE-31, No. 3, August 1965, Seiten 374 - 377, beschrieben.

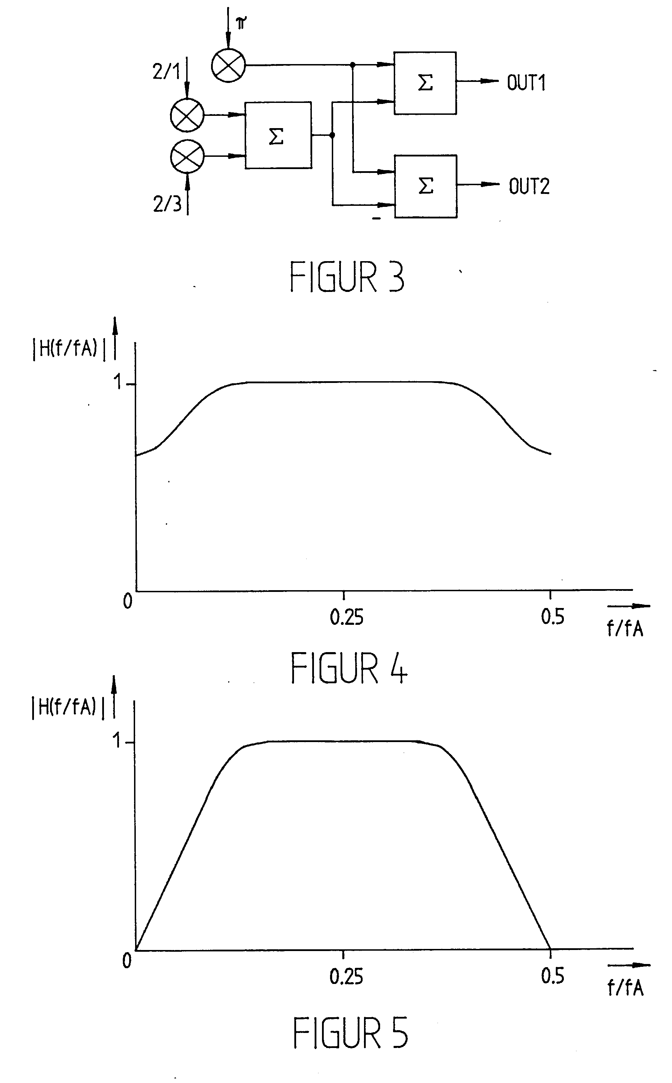

Als nachteilig ist dabei anzusehen, daß der Betragsfrequenzgang des Hilbert-Transformators bei den Frequenzen O Hz und Vielfachen der halben Abtastfrequenz Nullstellen aufweist, so daß ein steiler Abfall des Betragsfrequenzganges zu diesen Frequenzen hin erfolgt. Der qualitative Betragsfrequenzgang eines Hilbert-Transformator ist in Figur 5 dargestellt. Der Einsatzbereich des Hilbert-Transformators ist im wesentlichen auf den horizontalen Verlauf des Betragsfrequenzgangs beschränkt. Um die mögliche Bandbreite zu vergrößern muß der schaltungstechnische Aufwand für die Realisierung des Hilbert-Transformators erhöht werden.

Die Aufgabe der Erfindung ist es, eine Einrichtung zur Gewinnung zweier in Quadraturphasenbeziehung stehender Signale aus einem digitalen Signal anzugeben, welche es bei gleich großer Bandbreite erlaubt, den Realisierungsaufwand, verglichen mit dem Realisierungsaufwand für Hilbert-Transformator und Verzögerer, zu vermindern.

Erfindungsgemäß wird die Aufgabe dadurch gelöst, daß zwei Signale erzeugt werden, die um 45° bzw. -45° zum durch die Einrichtung verzögerten Eingangssignal phasenverschoben sind, so daß die erzeugten Signale über die Quadraturphasenbeziehung verknüpft sind.

Die erfindungsgemäße Einrichtung ist durch die Merkmale des Anspruchs 1 definiert. Vorteilhafte Ausgestaltungen und Weiterbildungen ergeben sich aus den Ansprüchen 2 und 3.

Die Vorteile der Erfindung bestehen insbesondere darin, daß zur Erzeugung der die Quadraturphasenbeziehung aufweisenden Signale das verzögerte Eingangssignal um 45° bzw. -45° verschoben wird, und daß die dazu erforderlichen Filter keine Nullstellen bei der Frequenz O Hz sowie Vielfachen der halben Abtastfrequenz aufweisen, so daß sich im Vergleich zum Stand der Technik ein flacherer Frequenzgang der Übertragungsfunktion ergibt.

Aus der symmetrischen Anordnung zur Erzeugung der über die Quadraturphasenbeziehung verknüpften Signale mittels Phasenverschiebung um 45° bzw. -45° resultiert der Vorteil symmetrischer Koeffizienten, so daß sich der Aufwand zur Bestimmung der Filterkoeffizienten sowie der Realisierungsaufwand verringert.

Nachfolgend wird die Ausführung der Erfindung anhand von in Figuren dargestellten Einrichtungen näher erläutert.

Es zeigt:
Figur 1 den prinzipiellen, symmetrischen Aufbau einer Einrichtung gemäß der Erfindung,
Figur 2 die erfindungsgemäße Einrichtung in einer ersten Ausführungsform,
Figur 3 eine Weiterbildung der Ausführungsform nach Figur 2,
Figur 4 den qualitativen Betragsfrequenzgang eines Filters mit 45° Phasenverschiebung, und
Figur 5 den qualitativen Betragsfrequenzgang eines Hilbert-Transformators.

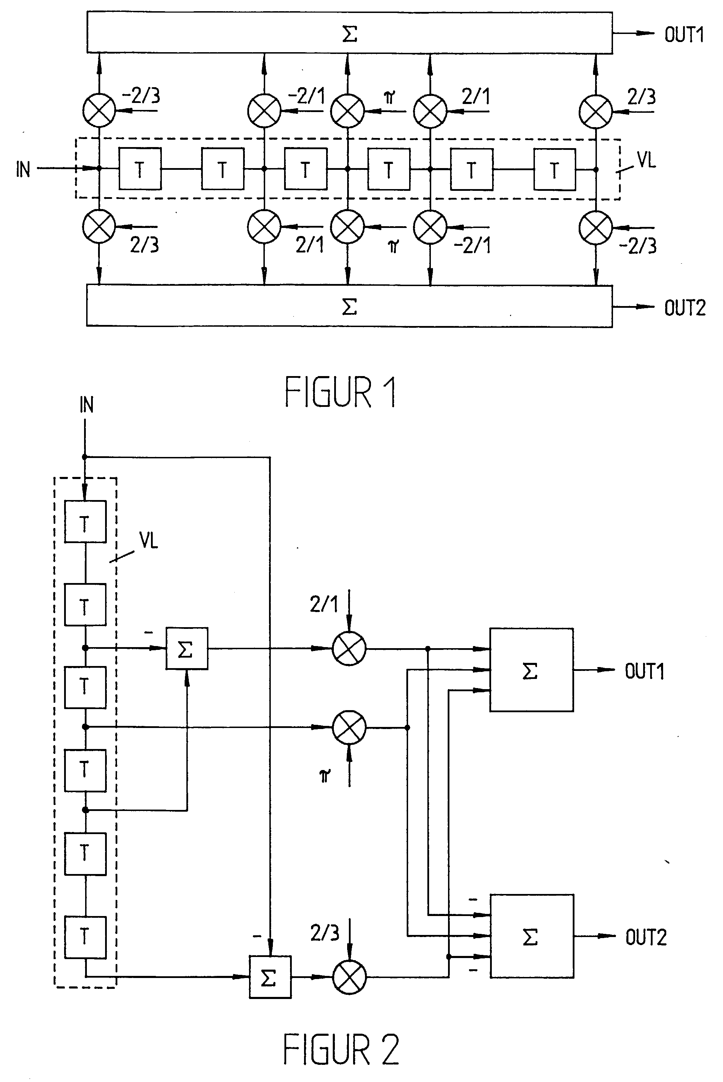

Figur 1 zeigt den prinzipiellen Aufbau der erfindungsgemäßen Einrichtung zur Erzeugung von zwei Signalen, die über die Quadraturphasenbeziehung verknüpft sind. Es ist ein Aufbau mit sechs Verzögerern gezeigt. Damit stehen sieben Abgriffmöglichkeiten für verschieden zeitlich verzögerte Abtastwerte des digitalen Eingangssignals IN zur Verfügung, weshalb derartig realisierte Filter auch 7-tap-Filter genannt werden. Um an den Ausgängen OUT1 und OUT2 der Einrichtung Signale zu erhalten, die um 45° bzw. -44^{o} zum um die Signallaufzeit der Filter verzögerten Eingangssignal IN verschoben sind, ergeben sich für die Filterstrukturen bezüglich des mittleren Abgriffs symmetrische Koeffizienten mit betragsmäßig gleichen Werten. Die notwendigen Koeffizienten lassen sich mittels bekannter Filterentwurfsverfahren bestimmen. So erhält man z.B. mit einem Fourier-Entwurfsverfahren für den Koeffizienten des mittleren Abgriffs die Kreiszahl und weiterhin - wenn dem mittleren Abgriff die Nummer Null zugeordnet wird, von der aus die Abgriffe nach links und rechts gezählt werden - für Koeffizienten mit geraden Abgriffnummern den Wert null und für Koeffizienten mit ungeraden Abgriffnummern den betragsmäßigen Wert durch die Division von zwei durch die Abgriffnummer. Die Koeffizienten für die Phasenverschiebung von 45° sind negativ für Koeffizienten links vom mittleren Abgriff und rechts davon positiv. Für die Phasenverschiebung von -45° sind die Vorzeichen der Koeffizienten umgekehrt. Der mittlere Koeffizient ist für beide Fälle positiv.
Abschließend werden die Koeffizienten der üblichen Fensterung, Quantisierung und Normierung unterworfen.

Die Signale der Abgriffe werden mit den so ermittelten Koeffizienten multipliziert und von zwei Addierern zu den Ausgangssignalen OUT1 und OUT2 zusammengefaßt.

Die Realisierung einer erfindungsgemäßen Einrichtung ist nicht auf den hier dargestellten Fall eines 7-tap-Filters beschränkt. Für die Realisierung sind, je nach Anforderung an die Ausgangssignale, auch Filterstrukturen mit mehr oder weniger Verzögerern möglich.

In Figur 2 ist eine Vereinfachung der Filterstruktur dargestellt, die sich aus der Symmetrie der Filter ergibt. Für mit gleichen Koeffizienten zu multiplizierende Abgriffe werden durch Subtrahierer die Differenzen gebildet. Diese Differenzen werden mit den entsprechenden Koeffizienten multipliziert, und die Ausgangssignale OUT1 und OUT2 werden durch zwei Addierer gebildet, wobei die mit den entsprechenden Koeffizienten multiplizierten Differenzen zur Bildung des Ausgangssignals OUT2 negiert werden.

Für den hier beschriebenen Fall einer 7-tap-Filterstruktur ergibt sich dadurch die Einsparung von sieben Multiplizierern sowie eine Vereinfachung bei den Addierern.

Figur 3 stellt eine weitere Vereinfachung dar und betrifft die beiden Addierer der Figur 2 zur Bildung der Ausgangssignale OUT1 und OUT2. Dazu ist ein dritter Addierer vorhanden, der die Summe der mit den zum mittleren Abgriff symmetrischen Koeffizienten multiplizierten Differenzen bildet. Diese Summe wird im ersten Addierer mit dem mit dem mittleren Koeffizienten multiplizierten Signal des mittleren Abgriffs zum Ausgangssignal OUT1 zusammengefaßt, während an den Eingängen des zweiten Addierers, zur Bildung des Signals OUT2, neben dem mit dem mittleren Koeffizienten multiplizierten Signal des mittleren Abgriffs, das invertierte Ausgangssignal des dritten Addierers anliegt.

## Patentansprüche

1. Einrichtung zur Gewinnung zweier in Quadraturphasenbeziehung stehender Signale (OUT1;OUT2) aus einem digitalen Signal, mit zwei Filtern mit endlicher Impulsantwort, deren Koeffizienten so festgelegt sind, daß die Ausgangssignale (OUT1;OUT2) in Quadraturphasenbeziehung stehen, wobei die beiden Filter eine Verzögerungseinheit (VL) verwenden, welche mindestens zwei Verzögerungselemente (T) aufweist,
**dadurch gekennzeichnet** ,
daß die Koeffizienten der Filter so festgelegt sind, daß die in Quadraturphasenbeziehung stehenden Ausgangssignale (OUT1;OUT2) zum um die Laufzeit der Filter verzögerten digitalen Eingangssignal (IN) um 45° und -45° verschoben sind.

2. Einrichtung nach Anspruch 1,
**dadurch gekennzeichnet,**
daß für betragsmäßig gleiche Koeffizienten der beiden Filter nur jeweils ein Multiplizierer vorgesehen ist, und
daß Subtrahierer vorhanden sind, die Differenzwerte der mit betragsmäßig gleichen Koeffizienten zu multiplizierenden, von der Verzögerungseinheit (VL) abgegriffenen Signalwerte des Eingangssignals (IN) bilden, und
daß ein erster Addierer aus den mit den jeweiligen Koeffizienten multiplizierten Differenzwerten ein erstes Signal (OUT1) bildet, das in Quadraturphasenbeziehung zu einem zweiten Signal (OUT2) steht, welches ein zweiter Addierer aus den mit den jeweiligen Koeffizienten multiplizierten, negierten Differenzwerten bildet, und
daß der erste und zweite Addierer einen weiteren Eingang für das mit dem mittleren Koeffizienten multiplizierten Signal des mittleren Abgriffs der Abgriff-Verzögerungsleitung (VL) aufweisen.

3. Einrichtung nach Anspruch 2,
**dadurch gekennzeichnet,**
daß, abhängig von der Länge der Verzögerungseinheit (VL), vor den ersten und zweiten Addierer weitere Addierer geschaltet sind, welche die Summe der mit den jeweiligen Koeffizienten multiplizierten Differenzwerte bilden.

## Claims

1. Device for obtaining two signals (OUT1; OUT2) which are in quadrature phase relationship from one digital signal, comprising two filters having finite pulse response whose coefficients are fixed in such a way that the output signals (OUT1; OUT2) are in quadrature phase relationship, the two filters using a delay unit (VL) which comprises at least two delay elements (T), characterized in that the coefficients of the filters are fixed so that the output signals (OUT1; OUT2) which are in quadrature phase relationship are shifted by 45° and -45° with respect to the digital input signal (IN) delayed by the transit time of the filters.

2. Device according to Claim 1, characterized
in that only one multiplier is provided in each case for quantitatively equal coefficients of the two filters, and
in that subtracters are present which form difference values of those signal values of the input signal (IN) which are to be multiplied by quantitatively equal coefficients and are picked up from the delay unit (VL), and
in that a first adder forms, from the difference values multiplied by the respective coefficients, a first signal (OUT1) which is in quadrature phase relationship with a second signal (OUT2) which a second adder forms from the negated difference values to be multiplied by the respective coefficients, and
in that the first and second adders have a further input for the signal, to be multiplied by the mean coefficient, of the centre tapping of the tapped delay line (VL).

3. Device according to Claim 2, characterized in that, depending on the length of the delay unit (VL), there are connected upstream of the first and second adders further adders which form the sum of the difference values multiplied by the respective coefficients.

## Revendications

1. Dispositif pour obtenir deux signaux (OUT1; OUT2) présentant entre eux une relation de phase en quadrature à partir d'un signal numérique, comportant deux filtres ayant une réponse impulsionnelle finie et dont les coefficients sont fixés de telle sorte que les signaux de sortie (OUT1; OUT2) présentent entre eux une relation de phase en quadrature, les deux filtres utilisant une unité de retardement (VL), qui comporte au moins deux éléments de retardement (T), caractérisé en ce que les coefficients des filtres sont fixés de telle sorte que les signaux de sortie (OUT1; OUT2), qui présentent entre eux une relation de phase en quadrature, sont décalés de 45° et de -45° par rapport au signal d'entrée numérique (IN) retardé du temps de propagation dans les filtres.

2. Dispositif selon la revendication 1, caractérisé en ce que pour des coefficients identiques en valeur absolue des deux filtres, il n'est prévu respectivement qu'un multiplicateur, et
que des soustracteurs sont prévus, qui forment les valeurs de différence des valeurs du signal d'entrée (IN), qui doivent être multipliées par des coefficients identiques en valeur absolue et sont prélevées de l'unité de retardement (VL), et
qu'un premier additionneur forme, à partir des valeurs de différence multipliées par les coefficients respectifs, un premier signal (OUT1), qui se situe dans une relation de phase en quadrature par rapport à un second signal (OUT2), qu'un second additionneur forme à partir des valeurs de différence négativées, multipliées par les coefficients respectifs, et
que les premier et second additionneurs possèdent une seconde entrée pour le signal, multiplié par le coefficient moyen, de la prise médiane de la ligne à retard à prises (VL).

3. Dispositif selon la revendication 2, caractérisé en ce qu'en fonction de la longueur de l'unité de retardement (VL), en amont des premier et second additionneurs sont branchés d'autres additionneurs, qui forment la somme des valeurs de différence multipliées par les coefficients respectifs.
